## Europäisches Patentamt
## European Patent Office
## Office européen des brevets

(19)

(11) Numéro de publication: **0 038 238**
**B1**

(12) **FASCICULE DE BREVET EUROPEEN**

(45) Date de publication du fascicule du brevet: **10.10.84**

(51) Int. Cl.³: **H 01 L 29/74,** H 01 L 29/76, H 01 L 29/80

(21) Numéro de dépôt: **81400494.1**

(22) Date de dépôt: **27.03.81**

(54) **Procédé de fabrication d'un dispositif semiconducteur à grille profonde accessible par la surface.**

(30) Priorité: **14.04.80 FR 8008270**

(43) Date de publication de la demande:
**21.10.81 Bulletin 81/42**

(45) Mention de la délivrance du brevet:
**10.10.84 Bulletin 84/41**

(84) Etats contractants désignés:
**AT BE CH DE FR GB IT LI LU NL SE**

(56) Documents cités:
**FR-A-2 257 148**
**FR-A-2 381 373**
**FR-A-2 394 175**
**GB-A-2 026 237**
**US-A-4 115 793**

**IBM TDB 23, (1980.09), 4, pages 1487/88**

(73) Titulaire: **THOMSON-CSF**
**173, Boulevard Haussmann**
**F-75379 Paris Cedex 08 (FR)**

(72) Inventeur: **Arnould, Jacques**
**THOMSON-CSF SCPI 173, bld Haussmann**
**F-75360 Paris Cedex 08 (FR)**
Inventeur: **Tonnel, Eugène**
**THOMSON-CSF SCPI 173, bld Haussmann**
**F-75360 Paris Cedex 08 (FR)**

(74) Mandataire: **de Beaumont, Michel et al**
**THOMSON-CSF SCPI 173, Bld Haussmann**
**F-75379 Paris Cedex 08 (FR)**

Courier Press, Leamington Spa, England.

EP 0 038 238 B1

**Description**

La présente invention concerne un procédé de fabrication de structures semiconductrices à grille profonde localisée accessible par la surface.

Dans divers types de composants semiconducteurs, discrets ou intégrés, tels que des transistors bipolaires de grande puissance, des thyristors ouvrables par la gâchette, des transistors à effet de champ vertical de puissance à jonction et autres, on trouve une couche profonde localisée en forme de grille disposée à l'intérieur de la plaquette semiconductrice dans un plan parallèle à celui des faces principales de cette plaquette.

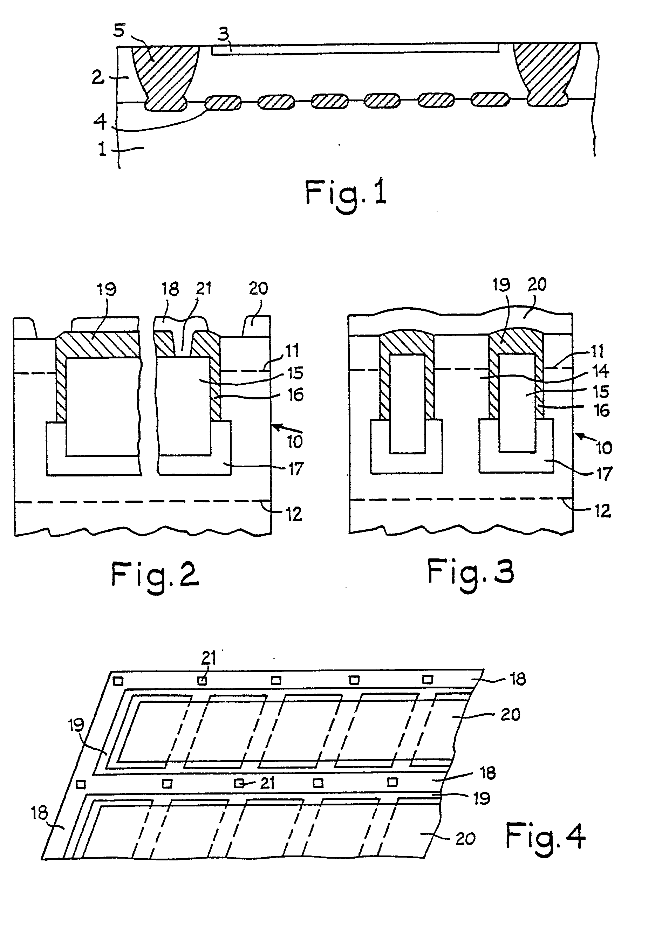

De telles couches profondes sont couramment désignées dans la technique par l'appellation grilles entrerrées en raison du procédé de fabrication classique de l'art antérieur par lequel elles étaient obtenues. En effet, ce procédé consistait à partir d'un substrat semiconducteur, à y implanter des atomes dopants selon le type de conductivité correspondant à celui de la grille que l'on voulait obtenir, puis à former au-dessus de ce substrat une ou plusieurs couches épitaxiées dans lesquelles sont éventuellement formées une ou plusieurs diffusions. Une telle structure est représentée schématiquement dans la figure 1 ci-jointe. On peut y voir le substrat 1 surmonté d'une couche épitaxiée 2 dans laquelle est formée une zone diffusée 3. La couche ou grille enterrée 4 est présente à la limite entre le substrat 1 et la couche épitaxiée 2. Ensuite, un contact est assuré entre la surface supérieure de la plaquette semiconductrice et la grille enterrée 4 au moyen d'une diffusion profonde 5. Dans de nombreuses applications pratiques, la grille 4 doit avoir un pas extrêmement fin et bien déterminé. En outre, cette grille sert couramment à l'ouverture du dispositif semiconducteur. Il est alors nécessaire que la résistivité transversale de la couche de grille soit la plus faible possible. Son niveau de dopage doit donc être très important. Le haut niveau de dopage rend difficile de maîtriser avec une grande précision l'étendue de la diffusion à partir de la couche initialement implantée pour que les mailles de la grille ne se ferment pas et aient une épaisseur prédéterminée. Le contrôle de cette diffusion est très délicat à réaliser notamment du fait des autres étapes de diffusion thermique qui doivent être prévues pour la formation des autres couches élaborées sur le substrat. Des diffusions parasites du dopant implanté peuvent également se produire lors de la formation de la couche épitaxiée.

Ces inconvénients sont d'autant plus notables que, dans de nombreux dispositifs, on a cherché à réaliser de façon pratique des dimensions de mailles de grilles de l'ordre de quelques mirons. D'autre part, du fait même de l'utilisation d'une couche épitaxiée déposée sur un substrat, il ne peut se développer entre les mailles de la grille, au niveau de l'interface entre la couche épitaxiée et le substrat, une charge d'espace nécessaire au bon fonctionnement du dispositif.

On connait cependant des dispositifs semiconducteurs dont une face comprend des rainures remplies d'un agent conducteur et dont les parois latérales sont revêtues d'un agent isolant sauf aux endroits où l'on désire réaliser le contact avec une zone interne déterminée. De tels dispositifs sont, par exemple, décrits dans FR—A—2 257 148 et dans l'article de H. H. BERGER et al publié dans IBM Technical Disclosure Bulletin, Vol. 23, N° 4, septembre 1980, pages 1487—1488.

Ainsi, un objet de la présente invention est de prévoir un nouveau procédé de fabrication de dispositif semiconducteur à grille profonde qui pallie les inconvénients structurels et de fabrication des dispositifs à grille enterrée de l'art antérieur.

Pour atteindre cet objet ainsi que d'autres, la présente invention prévoit la fabrication d'une structure de dispositif semiconducteur à grille profonde ne comprenant pas de couche enterrée sous une couche épitaxiée selon la technique qui a été adoptée au cours de ces dernières années.

Le procédé de fabrication d'un dispositif semiconducteur à grille profonde accessible par la surface comportant des sillons dont la partie la moins profonde est latéralement isolée et la partie la plus profonde entre directement dans le substrat, comprend les étapes suivantes: prévoir deux produits de protection sensibles à des produits d'attaque, distincts, recouvrir le substrat d'une couche 31 du premier produit de protection, former une rainure 32 d'une première profondeur, revêtir les parois de la rainure d'une couche 16 du produit de protection de deuxième type, enlever le deuxième produit de protection au fond de la rainure, approfondir cette rainure et remplir les sillons d'une substance conductrice.

La présente invention est mise en oeuvre simplement sur un substrat de silicium.

Dans ce cas, un procédé particulier de fabrication d'un dispositif selon la présente invention à partir d'un corps de silicium comportant diverses couches de type de conductivité et/ou de niveau de dopage distincts comprend les étapes suivantes: revêtir la face supérieure d'une couche de nitrure de silicium; ouvrir des fenêtres dans le nitrure de silicium et procéder à une attaque anisotrope pour former des rainures en U selon ce quadrillage; oxyder les parois des rainures; enlever la couche d'oxyde au fond des rainures; procéder éventuellement à une attaque anisotrope complémentaire pour approfondir les rainures; remplir les rainures de silicium polycristallin fortement dopé; procéder à une étape thermique pour faire diffuser le dopant dans le substrat sous l'emplacement du sillon non protégé par la silice et oxyder, pour la transformer en silice, la surface supérieure de silicium polycristallin dans les rainures; enlever sélectivement la couche de nitrure de silicium; ouvrir des fenêtres en des emplacements choisis sur la couche de silice pour faire apparaître des zones de contact sur le silicium polycristallin remplissant les rainures; procéder au dépôt d'une métallisation; graver la métallisation pour séparer une électrode principale en contact avec la première face et une électrode en contact avec le silicium polycristallin, c'est-à-dire la grille.

L'étape d'enlèvement de la couche de silice au fond des rainures en U peut être réalisée en attaquant par bombardement ionique, d'argon ou de bore par exemple, le fond des rainures et en attaquant sélectivement cette couche de silice ayant subi l'implantation par un produit d'attaque approprié, par exemple un mélange d'acide fluorhydrique et de fluorure d'ammonium.

Ces objets, caractéristiques et avantages ainsi que d'autres de la présente invention seront exposés plus en détail dans la description suivante de modes de réalisation particuliers faite en relation avec les figures jointes parmi lesquelles:

la figure 1 qui a été décrite précédemment était destinée à rappeler l'état de la technique;

Les figures 2 et 3 représentent des vues en coupe de modes de réalisation d'un dispositif à grille profonde obtenu selon la présente invention, prises selon des plans différents; et la figure 4 en représente une vue de dessus;

les figures 5 à 10 illustrent des étapes de fabrication d'un dispositif selon l'invention; et

les figures 11 et 12 illustrent des applications de la présente invention.

Les figures 2 et 3 représentent des vues en coupe partielle longitudinale et transversale de modes de réalisation d'un dispotif obtenu selon la présente invention.

Ce dispositif comprend un corps semiconducteur comprenant par exemple des jonctions 11 et 12 entre des couches semiconductrices de type et/ou de niveau de dopage distincts. Des zones en saillie 14 sont délimitées par des rainures 15. La partie supérieure de la paroi latérale de ces rainures est revêtue d'une couche d'un matériau isolant 16; le fond des rainures ainsi que les parties des parois latérales non isolées par la couche 16 sont éventuellement entourés d'une zone 17 à niveau de dopage et de type de conductivité choisis. L'intérieur des sillons ou rainures est rempli d'un produit électriquement conducteur 15 assurant un contact ohmique avec les zones 17 ou un contact direct, ohmique ou non, avec le fond du sillon si les zones 17 n'existent pas pour servir de couche de conduction électrique entre une électrode 18 sur la face supérieure du corps semiconducteur et les couches ou zones en contact avec le fond du sillon. Une deuxième électrode 20 assure le contact électrique avec la partie non sillonnée de la face supérieure.

Dans un mode de réalisation particulier de la présente invention, la partie supérieure du produit conducteur 15 remplissant les rainures est isolée par une couche d'isolement 19 et seulement quelques fenêtres 21 sont prévues dans cette couche d'isolement 19 pour assurer le contact entre la métallisation 18 et le produit conducteur remplissant chaque rainure. Ceci permet de réaliser la couche métallique 20 de contact avec la face supérieure de façon continue en évitant de prévoir des ouvertures de cette couche de métallisation en regard de chacune des rainures.

On peut ainsi obtenir une structure à grille profonde présentant par rapport aux structures à grille enterrée de l'art antérieur de nombreux avantages structurels résultant notamment du fait que: la zone diffusée 17 est nettement délimitée par la partie du sillon isolée latéralement 16; les contacts d'électrode principale sur la face supérieure et d'électrode de grille sont ramenés sur un même plan et leur réalisation peut être simplifiée; enfin et surtout comme cela sera exposé ci-après, en relation avec un exemple particulier, la structure selon la présente invention peut être fabriquée de façon simple tout en obtenant une miniaturisation extrême des diverses dimensions.

Dans le cas particulier où le substrat semiconducteur 10 est un substrat de silicium, on choisira celui-ci selon une orientation (1, 1, 0). Les sillons 32 sont formés dans le substrat par gravure anisotrope. Les gravures forment préférentiellement, comme le représente la vue de dessus de la figure 4, des parallélogrammes d'angles 70° et 110°. Le matériau d'isolement 16 des rainures est de préférence de la silice, le matériau conducteur 15 de remplissage de ces rainures est de préférence du silicium polycristallin dopé et la zone de grille 17 est de préférence une zone diffusée obtenue par diffusion dans le substrat d'atomes dopants initialement contenus dans le silicium polycristallin. Les métallisations 18 et 20 sont de préférence des métallisations d'aluminium. A titre d'exemple, on pourra réaliser un dispositif pratique à grille parallélépipèdique présentant les caractéristiques dimensionnelles suivantes:

—— profondeur totale des sillons: 5 à 50 microns
—— distance entre sillons: 10 à 15 microns
—— largeur des sillons: 3 à 5 microns
—— largeur ou profondeur de la couche 17: 2 à 3 microns
—— longeur des sillons: 0,5 à 1 mm

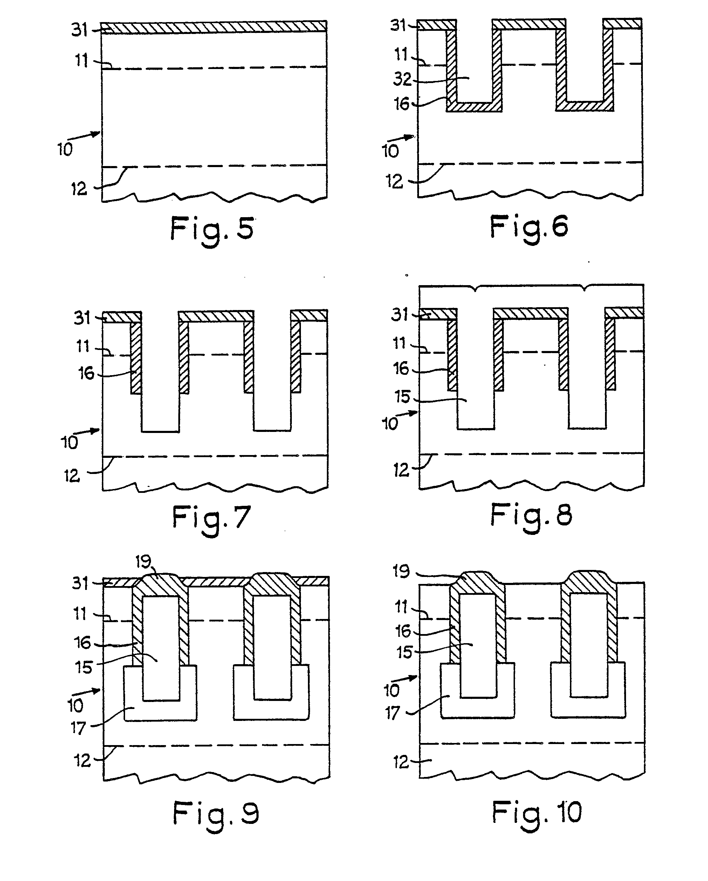

Dans le cas où le dispositif aurait la configuration digitée représentée en vue de dessus en figure 6, le doigt de métallisation destiné à venir prendre un contact avec des ouvertures 21 en plusieurs points de la grille peut avoir une largeur de l'ordre de 30 à 50 microns.

Un procédé de fabrication d'une structure telle que représentée en figures 2 à 4 réalisée sur substrat de silicium (1, 1, 0) va maintenant être décrit plus en détail en relation avec les figures 5 à 10.

La figure 5 représente un corps de silicium 10 comportant des jonctions 11 et 12, sur la première face ou face supérieure duquel on a formé une couche de protection 31 en nitrure de silicium ($Si_3N_4$). Des ouvertures sont formées en des emplacements choisis de la couche de nitrure de silicium, par exemple selon le quadrillage en parallélogrammes représenté en vue de dessus en figure 4. Ces ouvertures dans la couche de nitrure de silicium servent de masque d'attaque pour effectuer une gravure anisotrope de la plaquette et fournir les sillons en U 32 représentés dans la figure 6. Les crêtes des ouvertures sont alignées sur les directions (2, 1, 1) et les faces latérales sont constituées par des plans (1, 1, 1). Une étape d'échauffement thermique en atmosphère oxydante permet d'oxyder les parois des rainures de façon à former une couche d'isolement 16 en silice ($SiO_2$).

On procède ensuite à une implantation d'ions, d'argon ou de bore par exemple, selon une incidence normale à la surface de la plaquette de façon à réaliser cette implantation dans la couche de silice se trouvant au fond des rainures 32. Il est alors possible d'attaquer sélectivement par un produit d'attaque de dosage approprié le fond des sillons que a reçu l'implantation sans attaquer les parois de ces sillons ni la couche de nitrure à la surface de la plaquette.

Comme le représente schématiquement la figure 7, après ce enlèvement de la couche d'oxyde au fond des sillons, on procède éventuellement à une attaque anisotrope complémentaire pour approfondir ces sillons ou rainures qui gardent toujours néanmoins leur forme en U. On obtient ainsi des sillons dont la partie supérieure est isolée par la couche de silice 16 et dont la partie la plus profonde pénètre sans couche intermédiaire dans le silicium du substrat. Si l'on n'a pas procédé à une attaque complémentaire, seul le fond des sillons laisse apparaître le silicium du substrat. Le sillon est ensuite rempli de silicium polycristallin 15 dopé, par exemple de type $P^+$ (au bore) des techniques existant actuellement pour effectuer de tels dépôts à des températures relativement basses (inférieures à 600°C).

Comme le représente la figure 9, le silicium polycristallin en excès sur la face supérieure du dispositif est enlevé par un produit d'attaque approprié, par exemple par une attaque sous plasma, et l'on procède à une étape d'échauffement pour fournir une couche de silice 19 à la partie supérieure des rainures et également pour assurer la diffusion des atomes dopants contenus dans le silicium polycristallin 15 (par exemple du bore) vers le substrat pour former les zones 17. On notera néanmoins que pour certains dispositifs il n'est pas nécessaire de former les zones 17.

Lors de l'étape illustrée en figure 10 on enlève la couche de nitrure de silicium 31. Après quoi l'on procède à des ouvertures de contact dans la couche de silice 19 puis à une métallisation, par exemple d'aluminium, des faces supérieures et inférieures du dispositif. La couche d'aluminium sur la face supérieure est gravée pour séparer l'électrode principale de l'électrode de grille en contact avec le silicium polycristallin 15 en les emplacements définis par les fenêtres ouvertes dans la couche d'oxyde 19. On obtient ainsi un dispositif selon l'invention tel que représenté dans les figures 2 à 4.

Selon l'un des avantages de la présente invention, l'étape de formation de la couche de grille proprement dite 17 est l'une des dernières étapes du procédé de fabrication et n'est suivie d'aucune autre étape de diffusion, c'est-à-dire d'échauffement important. Ainsi, la profondeur ou épaisseur de la zone 17 à partir du sillon peut être contrôlée avec une grande précision. On évite les phénomènes d'exo-diffusion qui rendent si difficile technologiquement la réalisation de structures à grille enterrée à pas très fin du type de celle illustrée en figure 1.

Bien entendu, le procédé de fabrication selon la présente invention est susceptible de nombreuses variantes, par exemple en ce qui concerne l'attaque du fond de la couche d'oxyde dans les sillons illustrée en figure 6 et le procédé de formation de la couche 17. Celle-ci pourrait être formée à partir d'un dopant implanté ou diffusé à partir de la structure se trouvant dans l'état de la figure 7, le silicium polycristallin 15 de remplissage des sillons étant disposé ultérieurement. Ceci permet un contrôle indépendant de la diffusion de la jonction $P^+$ et de la conductivité transversale de la grille par le remplissage du silicium polycristallin de type $P^+$ 15. Selon une variante de la présente invention, le matériau conducteur remplissant les sillons, au lieu d'être du silicium polycristallin, peut-être un composé de silicium et d'un métal réfractaire tel que du platine, du tungstène ou du molybdène, ce qui permet de disposer d'un matériau conducteur de plus faible résistivité que le silicium polycristallin. Dans le cas où l'on utilise un tel composé de silicium et de métal réfractaire, on réalisera, dans le cas où il convient de prévoir des couches 17, une implantation préalable de ces couches. On notera qu'un avantage d'un composé silicium + métal réfractaire est qu'il peut s'oxyder en surface comme le silicium polycristallin. Il tend alors d'ailleurs, lors d'une étape d'oxydation, à se produire une séparation entre le silicium et le métal réfractaire, le silicium transformé en silice apparaissant à la périphérie dans les zones oxydées, ce qui améliore encore la résistivité. On notera également que la présente invention, même dans le cas d'un substrat de silicium, ne se limite pas à la formation de sillons par attaque anisotrope. Des techniques sont maintenant connues pour former des sillons profonds et de très faibles largeurs par gravure ionique. En fonction de considérations techniques et économiques on pourra préférer ce mode de réalisation des sillons ou tout autre mode connu.

Exemples d'applications de la presente invention

— fabrication de transistors de grande puissance à grille de base enterrée.

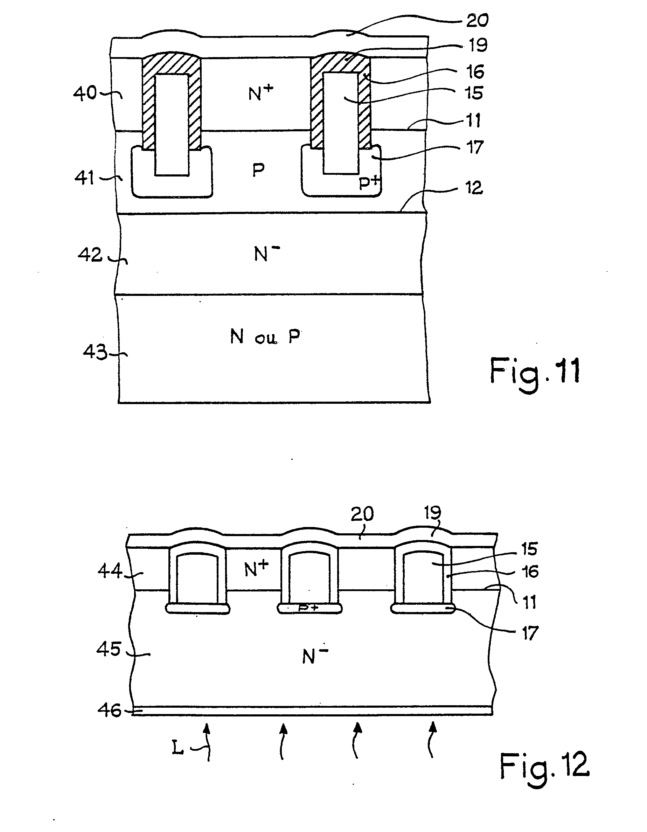

Comme le montre la figure 11, ces transistors comprennent un émetteur 40 de type $N^+$ sur une base 41 de type P et sur un collecteur constitué d'une couche 42 de type N- puis d'une couche superficielle 43 de type $N^+$. On cherche alors à réaliser une grille de base à haut niveau de dopage $P^+$ à l'intérieur de la base de type P ou à prendre un contact direct avec divers emplacements de la couche de base. Les sillons selon la présente invention sont alors formés pour que leur fond ébouche dans la couche de base 41 de type P. On peut réaliser simplement des contacts de base multiples en ne prévoyant pas de zones diffusées de type $P^+$ 17 ou bien former effectivement une grille profonde à haut niveau de dopage en formant des zones diffusées 17.

— fabrication de thyristors ouvrables par la gâchette.

Ces thyristors ont une structure analogue à celle des transistors représentés en figure 11 sauf que la couche 43 est alors une couche de type P et non plus une couche de type N.

— fabrication de transistors à effet de champ de type vertical à jonction.

Ces structures comprennent un substrat de type N à l'intérieur duquel on forme une grille de type $P^+$.

— fabrication de cellules solaires multijonctions horizontales (figure 12).

Cette cellule ou ensemble de diodes comprend une couche 44 de type $N^+$ sur un substrat 45 de type N-. La face inférieure du substrat est revêtue d'une couche anti-reflets 46 qui reçoit un faisceau lumineux incident concentré L. Dans cette application, les sillons sont formés en une seule fois et traversent la couche de type $N^+$ 44 pour pénétrer dans la couche de type N- 45. Le fond des sillons repose sur une couche de type $P^+$17 formée par exemple, comme cela a été exposé précédemment à partir de silicium polycristallin 15 dopé de type $P^+$ et remplissant les sillons. On peut également prévoir, comme cela a été indiqué à titre de variante de l'invention que les zones 17 de type $P^+$ soient formées par implantation au fond des sillons avant le remplissage de ceux-ci par un matériau conducteur 15. Par rapport à une structure MJH (multijonctions horizontales) classique, la structure selon la présente invention présente d'une part l'avantage d'une plus grande compacité, étant donné que, dans une structure classique, les zones $N^+$ et $P^+$ adjacentes doivent être séparées par une zone à faible niveau de dopage qui correspond à de la place perdue. D'autre part, la formation de la façon exposée précédemment de la couche isolante 19 à la limite entre le matériau conducteur 15 remplissant les sillons et la métallisation 20 recouvrant la diode permet de prendre une métallisation de grande dimension en contact avec toutes les zones $N^+$ et pouvant être montée sur un radiateur, les contacts avec les sillons pouvant être pris sur un bord ou à la périphérie de la cellule solaire.

— Bien entendu la présente demande est susceptible d'autres applications, et notamment le mot grille tel qu'il est employé dans la présente description et dans les revendications ci-après doit se comprendre de façon générale comme désignant éventuellement une zone limitée profonde dans un corps semiconducteur ayant une forme autre qu'un quadrillage, par exemple un anneau ou même un ensemble de zones disjointes.

En effet, en ce qui concerne cette dernière application et les précédentes, on notera qu'un avantage de la présente invention réside dans le fait que le procédé exposé permet d'atteindre une couche profonde en formant un sillon occupant une surface minimale sur la plaquette semiconductrice alors que la prise de contact avec une couche profonde réalisée par une diffusion descendante telle que désignée par la référence 5 en figure 1 occupe une surface nettement plus importante sur la plaquette semiconductrice. D'autre part, quand on procède par diffusion descendante, il faut veiller à la disposition des couches pour que cette diffusion descendante ne provoque pas de courts-circuits ou de jonctions parasites entre couches distinctes. Au contraire, en utilisant le procédé selon la présente invention, du fait que les sillons sont isolés sur au moins une partie de leur surface latérale, on évite tout risque de court-circuit avec les couches rencontrées entre la couche profonde et la surface de la plaquette semiconductrice; il en résulte une simplification d'ensemble de la conception de certains dispositifs semiconducteurs.

En revenant sur les figures, il convient de souligner que, conformément à l'usage dans le domaine de la représentation des semiconducteurs, les diverses dimensions des couches et structures ne sont pas représentées à l'échelle, ni d'une figure à l'autre ni à l'intérieur d'une même figure. D'autre part, en ce qui concerne les figures 2 à 4, ces figures ne correspondent pas à des vues selon des plans différents d'un même mode de réalisation. Si l'on part de la figure 4, qui représente une structure à quadrillage de rainures, la figure 3 pourrait correspondre à une vue en coupe perpendiculairement à la grande longueur des sillons sous l'électrode 20, et la figure 4 montre, à titre d'exemple, comment pourraient être disposées les fenêtres 21 permettant un accès à la grille avec des électrodes principales (20) et de grille (18) digitées. Par contre la figure 2 représente une vue en coupe longitudinale d'un sillon unique n'appartenant pas à un quadrillage et la métallisation de grille 18 et la fenêtre 21 de cette figure 2 ne correspondent pas au mode de réalisation de la figure 4.

**Revendications**

1. Procédé de fabrication d'un dispositif semiconducteur à grille profonde accessible par la surface comportant des sillons dont la partie la moins profonde est latéralement isolée et la partie la plus profonde entre directement dans le substrat, comprenant les étapes suivantes:
prévoir deux produits de protection sensibles à des produits d'attaque distincts;
recouvrir le substrat d'une couche (31) du premier produit de protection;
former une rainure (32) d'une première profondeur;
revêtir les parois de la rainure d'une couche (16) du produit de protection de deuxième type;
caractérisé en ce qu'il comprend en outre les étapes consistant à enlever le deuxième produit de protection au fond de la rainure, à approfondir cette rainure et à remplir les sillons d'une substance conductrice (15).

2. Procédé selon la revendication 1, dans lequel le substrat est un substrat de silicium recouvert d'une couche de nitrure de silicium, caractérisé en ce qu'il comprend les étapes suivantes;
ouvrir la couche de nitrure de silicium aux endroits où on souhaite effectuer les sillons;
former ces sillons selon une première profondeur par attaque chimique d'une durée déterminée;
procéder à une étape d'oxydation pour oxyder les parois et le fond du sillon;
bombarder ioniquement le fond des sillons pour le rendre sélectivement sensible à une attaque chimique;
enlever par attaque chimique la silice bombardée déposée au fond des sillons;
approfondir les sillons d'une valeur déterminée par une deuxième attaque chimique.

3. Procédé de fabrication selon l'une des revendications 1 et 2, caractérisé en ce que la substance conductrice est du silicium polycristallin fortement dopé.

4. Procédé selon la revendication 3, caractérisé en ce qu'il comprend l'étape consistant à procéder à une étape d'échauffement pour faire diffuser des atomes dopants contenus dans le silicium polycristallin dans le substrat au voisinage du fond des sillons ainsi que dans la partie latérale des sillons non revêtue de la couche de silice (16).

5. Procédé selon l'une des revendications 3 ou 4, caractérisé en ce que la surface supérieure du silicium polycristallin contenu dans les rainures est transformée en une couche isolante de silice (19).

6. Procédé selon la revendication 5 dans lequel des électrodes métalliques sont formées sur la première face du dispositif, caractérisé en ce qu'il comprend les étapes suivantes:
ouvrir en certains emplacements de la couche de silice (19) selon la revendication 5 des fenêtres (21) permetant un accès vers la zone de silicium polycristallin (15);
déposer uniformément une couche de métallisation (20) telle que de l'aluminium sur la première face du dispositif;
graver cette couche selon une structure digitée pour séparer une électrode de grille (18) passant sur lesdites fenêtres et une électrode principale (20) recouvrant la plus grande partie de la première face.

**Patentansprüche**

1. Verfahren zur Herstellung einer Halbleitervorrichtung mit eingesenkter Gitterelektrode, die von der Oberfläche her zugänglich ist, welche Rillen aufweist, wovon wenigstens der am wenigsten tiefe Teil seitlich isoliert ist und der tiefste Teil direkt in das Substrat eindringt, mit folgenden Schritten:
Vorsehen von zwei Schutzstoffen, die durch verschiedene Ätzmittel angreifbar sind;
Bedecken des Substrats mit einer Schicht (31) aus dem ersten Schutzstoff;
Bilden einer Rille (32) mit einer ersten Tiefe;
Bedecken der Wände der Rille mit einer Schicht (16) des Schutzstoffes vom zweiten Typ;
dadurch gekennzeichnet, daß es ferner die Schritte umfaßt, die darin bestehen, den zweiten Schutzstoff vom Boden der Rille zue entfernen, diese Rillen zu vertiefen und die Rillen mit einer leitfähigen Substanz (15) auszufüllen.

2. Verfahren nach Anspruch 1, bei welchem das Substrat ein Siliciumsubstrat ist, das mit einer Siliciumnitridschicht bedeckt ist, dadurch gekennzeichnet, daß es folgende Schritte umfaßt:
Öffnen der Siliciumnitridschicht an denjenigen Stellen, wo die Rillen gebildet werden sollen;
Bildung dieser Rillen mit einer ersten Tiefe durch chemische Ätzung während einer bestimmten Dauer;
Vornahme eines Oxidationsschrittes zum Oxidieren der Wände und des Bodens der Rille;
Ionenbeschuß des Bodens der Rillen, um ihn selektiv für eine chemische Ätzung angreifbar zu machen;
durch chemisches Ätzen erfolgende Entfernung des am Boden der Rillen abgelagerten Siliciumdioxids nach dessen Beschuß;
Vertiefung der Rillen um einen bestimmten Wert mittels zweiter chemischer Ätzung.

3. Herstellungsverfahren nach einem der Ansprüche 1 und 2, dadurch gekennzeichnet, daß die leitfähige Substanz hochdotiertes polykristallines Silicium ist.

4. Verfahren nach Anspruch 3, dadurch gekennzeichnet, daß es den Schritt umfaßt, der darin besteht, eine Wärmebehandlung vorzunehmen, um die in dem polykristallinen Silicium enthaltenen Dotieratome in das Substrat in der Nähe des Bodens der Rillen sowie in den seitlichen Teil der Rillen, der nicht von der Siliciumdioxidschicht (16) bedeckt ist, einzudiffundieren.

5. Verfahren nach Anspruch 3 oder 4, dadurch gekennzeichnet, daß die Oberseite des polykristallinen Siliciums, das in den Rillen enthalten ist, in eine isolierende Siliciumdioxidschicht (19) umgewandelt wird.

6. Verfahren nach Anspruch 5, bei welchem metallische Elektroden auf der ersten Fläche der Vorrichtung gebildet werden, dadurch gekennzeichnet, daß es folgende Schritte umfaßt:
Öffnen von Fenstern (21), die einen Zugang zu der polykristallinen Siliciumzone (15) gestatten, an bestimmten Stellen der Siliciumdioxidschicht (19) nach Anspruch 5;
gleichförmiges Aufbringen einer Metallisierungsschicht (20), zum Beispiel aus Aluminium, auf der ersten Fläche der Vorrichtung;
Gravierung dieser Schicht gemäß einer Fingerstruktur zur Trennung einer Gitterelektrode (18), die über die genannten Fenster verläuft, von einer Hauptelektrode (20), welche den größten Teil der ersten Fläche bedeckt.

**Claims**

1. Method of producing a semiconductor device having a deep grid accessible from the surface comprising grooves the least deep portion of which is laterally insulated and the deepest portion of which enters directly into the substrate, comprising the following steps:
providing two protection products which are attackable by different attacking products.
covering the substrate with a layer (31) of the first protection product;
forming a groove (32) of a first depth;
covering the walls of the groove with a layer (16) of the protection product of the second type;
characterized in that it further comprises the steps consisting in removal of the second protection product from the bottom of the groove, deepening of this groove and filling the grooves with a conducting substance (15).

2. Method according to claim 1, wherein the substrate is a silicon substrate covered by a layer of silicon nitride, characterized in that it comprises the following steps:
opening the silicon nitride layer at the locations where the grooves are desired to be made;
forming of grooves with a first depth by chemical attack of determined duration;
proceeding with an oxidation step for oxidizing of the walls and the bottom of the groove;
ion bombarding of the bottom of the grooves to make it selectively attackable by a chemical attack.
removal of the bombarded silica deposited at the bottom of the grooves, by chemical attack;
deepening of the grooves to a determined value by a second chemical attack.

3. Production method according to any of claims 1 and 2, characterized in that the conducting substance is highly doped polycrystalline silicon. –

4. Method according to claim 3, characterized in that it comprises the step consisting in proceeding with a thermal step for diffusing the dopant atoms contained within the polycrystalline silicon into the substrate in the neighborhood of the bottom of the grooves as well as into the lateral portion of the grooves not covered by the silica layer (16).

5. Method according to any of claims 3 and 4, characterized in that the upper surface of the polycrystalline silicon contained within the grooves is transformed into an insulating silica layer (19).

6. Method according to claim 5, wherein metallic electrodes are formed on the first face of the device, characterized in that it comprises the following steps:
opening of windows (21) allowing an access to the zone of polycrystalline silicon (15), at determined locations of the silica layer (19) according to claim 5;
uniform deposition of a metallization layer (20) such as aluminum on the first face of the device;
engraving of this layer according to a digitated structure to separate a grid electrode (18) passing over said windows from a main electrode (20) covering the major portion of the first face.

Fig. 1

Fig. 2

Fig. 3

Fig. 4

1

Fig. 5

Fig. 6

Fig. 7

Fig. 8

Fig. 9

Fig. 10

2

Fig.11

Fig.12